# FASCICULE DE BREVET EUROPEEN

(11) **EP 3 077 873 B1**
(45) Date de publication et mention de la délivrance du brevet: **14.02.2018**
(21) Numéro de dépôt: 14814785.3
(22) Date de dépôt: 28.11.2014
(51) Int. Cl.: G03F 9/00

(54) **DISPOSITIF ET PROCEDE DE POSITIONNEMENT DE MASQUE DE PHOTOLITHOGRAPHIE PAR METHODE OPTIQUE SANS CONTACT**
VORRICHTUNG UND VERFAHREN ZUR POSITIONIERUNG EINER FOTOLITHOGRAFISCHEN MASKE MITTELS EINES BERÜHRUNGSLOSEN OPTISCHEN VERFAHRENS
DEVICE AND METHOD FOR POSITIONING A PHOTOLITHOGRAPHY MASK BY MEANS OF A CONTACTLESS OPTICAL METHOD

(30) Priorité: 04.12.2013 FR 1362065
(43) Date de publication de la demande: 12.10.2016
(73) Titulaire: Unity Semiconductor, 38330 Montbonnot-Saint-Martin (FR)
(72) Inventeur: FRESQUET, Gilles, F-30190 Garrigues Sainte Eulalie (FR); RIBETTE, Guenael, F-35370 Argentre du Plessis (FR)
(74) Mandataire: Pontet Allano & Associes
(86) Numéro de dépôt international: PCT/EP2014/076009
(87) Numéro de publication internationale: WO 2015/082363

(56) Documents cités:
- US-A- 6 088 103
- US-A1- 2006 110 070
- US-A1- 2007 242 271
- US-A1- 2013 141 704

## Description

### Domaine technique

La présente invention concerne un dispositif pour positionner un masque de photolithographie par rapport à la surface d'un wafer, afin d'effectuer des opérations d'insolation de wafer ou de substrat, en photolithographie mode contact/proximité notamment.

Elle concerne aussi un appareil comprenant un tel dispositif, et un procédé mis en oeuvre dans ce dispositif ou cet appareil.

Le domaine de l'invention est plus particulièrement, mais de manière non limitative, celui des steppers et des systèmes d'insolation en photolithographie.

### Etat de la technique antérieure

Les techniques de photolithographie nécessitent des opérations d'insolation des wafers en cours de process.

Le wafer à traiter comprend une couche à graver, recouverte d'une couche photosensible dite de « resist ». Un masque avec des parties transparentes et des parties opaques est positionné au dessus de la surface du wafer. Puis la surface du wafer est illuminée ou insolée au travers du masque avec une lumière en général dans les longueurs d'onde ultraviolettes (UV). Dans les parties transparentes du masque, la lumière atteint le wafer et modifie les propriétés de la couche photosensible. Après une étape de traitement chimique, les parties de la couche de resist situées dans les zones insolées ou dans les zones protégées selon le process (résine positive ou négative), sont éliminées pour permettre la gravure sélective des parties mises à nu de la couche à graver.

Ces opérations peuvent être répétées de nombreuses fois au cours d'un process. Le masque doit donc être positionné avec une grande précision par rapport à la surface du wafer, afin que le chemin optique du rayonnement d'insolation soit perpendiculaire et égal sur l'ensemble du wafer ou du substrat, qui comprend en général des structures déjà existantes.

Le positionnement dans le plan X-Y (parallèlement au plan du wafer) est en général effectué en superposant des motifs (réticules, croix, ...) présents sur le masque avec des motifs déjà gravés sur la surface du wafer. Le masque doit être positionné à une distance permettent de réaliser cet alignement sans altérer la couche de résine photosensible par contact.

Le masque doit ensuite être également positionné à une distance Z constante et très précise par rapport à la surface du wafer, et cela sur toute sa surface. Cela permet de maîtriser la diffraction de la lumière qui traverse le masque. En effet cette diffraction détermine directement la précision et la résolution avec laquelle les motifs du masque peuvent être reproduits sur le wafer. La maîtrise de cette distance Z est d'autant plus importante que l'on met en oeuvre des longueurs d'onde courtes (UV ou Deep UV ou extrême UV EUV) pour précisément limiter les effets de la diffraction et maximiser la résolution spatiale de la gravure.

Le masque ne doit pas être en contact avec le wafer. Il est en général positionné à une distance Z de l'ordre de 20 micromètres ou moins.

Dans les systèmes d'insolation contact/proximité connus, le positionnement des masques est réalisé avec des microbilles ou des cylindres, en céramique, de diamètre calibré qui font office de cales d'épaisseur. Ces microbilles ou cales d'épaisseur sont solidaires d'éléments mobiles permettent de les intercaler entre le masque et le wafer, puis l'ensemble est pressé.

Cette technique présente un certain nombre d'inconvénients :
- elle conduit à des systèmes complexes ;
- le contact mécanique est susceptible d'altérer les surfaces en contact ;
- la maîtrise du positionnement dans le plan X-Y et en distance Z du masque est complexe, car les surfaces ne doivent être pressées de part et d'autre des cales que lorsque le positionnement X-Y est effectué ;
- la précision du contrôle de l'épaisseur n'est pas toujours suffisante ;
- il n'est pas possible de diminuer la distance Z en dessous d'une certaine limite, ce qui est pourtant souhaitable pour limiter la diffraction.

On connait le document US 6 088 103 qui décrit un système pour aligner un wafer et un masque, et qui comprend une source de lumière pour illuminer des réseaux de diffraction et un système d'imagerie avec une caméra pour détecter les patterns de diffraction. Ce système permet de mesurer des désalignements dans le plan des réseaux de diffraction, et/ou une distance entre ces réseaux de diffraction ou entre un réseau et une surface par rétro-réflexion au travers de ce réseau.

La présente invention a pour objet de proposer un dispositif et un procédé pour positionner un masque par rapport à un wafer à insoler qui permet de résoudre les inconvénients de l'art antérieur.

La présente invention a également pour objet de proposer un dispositif et un procédé pour positionner un masque par rapport à un wafer ou un substrat à insoler qui permet un positionnement sans contact mécanique avec la surface du wafer.

La présente invention a enfin pour objet de proposer un dispositif et un procédé pour positionner un masque par rapport à un wafer ou un substrat à insoler qui permet de positionner précisément le masque à une distance très faible du wafer.

### Exposé de l'invention

Cet objectif est atteint avec un dispositif selon la revendication 1.

Suivant des modes de réalisation, le dispositif selon l'invention peut comprendre en outre des seconds moyens de positionnement aptes à déplacer le ou les champ(s) de vue relativement à la surface du wafer.

Suivant des modes de réalisation, le dispositif selon l'invention peut comprendre des moyens d'imagerie aptes à produire simultanément au moins trois images selon trois champs de vue.

Il peut comprendre au moins trois capteurs optiques de distance.

Suivant des modes de réalisation, le dispositif selon l'invention peut comprendre au moins un capteur optique de distance de l'un des types suivants :
- capteur confocal,
- capteur confocal chromatique,
- interféromètre à faible cohérence (temporelle, spectrale, à balayage de fréquence),
- reflectomètre,
- interféromètre laser.

Suivant des modes de réalisation, le dispositif selon l'invention peut comprendre au moins un capteur de distance qui est en outre apte à produire au moins l'une des mesures suivantes :
- une mesure d'épaisseur de la couche de resist,
- une mesure de réflectivité de la couche à graver présente sous la couche de resist.

Suivant un autre aspect, il est proposé un appareil d'insolation de wafers, comprenant un dispositif selon l'invention pour positionner un masque relativement à la surface d'un wafer.

Suivant encore un autre aspect, il est proposé un procédé selon la revendication 8.

Le procédé selon l'invention peut comprendre en outre une étape de déplacement relatif du masque et/ou du wafer de telle sorte à, dans au moins un champ de vue :
- superposer des repères de positionnement du masque et du wafer,
- obtenir une mesure de distance entre la surface du wafer et le masque qui soit conforme à une valeur prédéfinie.

Suivant des modes d'implémentation, le procédé selon l'invention peut comprendre une étape d'obtention, simultanément, d'au moins trois images selon trois champs de vue.

Le procédé selon l'invention peut comprendre en outre une étape de mesure, avec le capteur optique de distance, d'au moins l'une des grandeurs suivantes :
- l'épaisseur de resist présent sur le wafer,
- la réflectivité de la couche à graver présente sous le resist, à partir du signal capté par ledit capteur optique de distance.

### Description des figures et modes de réalisation

D'autres avantages et particularités de l'invention apparaîtront à la lecture de la description détaillée de mises en oeuvre et de modes de réalisation nullement limitatifs, et des dessins annexés suivants :
- la Fig. 1 illustre la problématique du positionnement d'un masque relativement à un wafer, avec à la Fig. 1(a) une vue de face et à la Fig. 1(b) une vue de côté,
- la Fig. 2 illustre un mode de réalisation de dispositif selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détails structurels, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

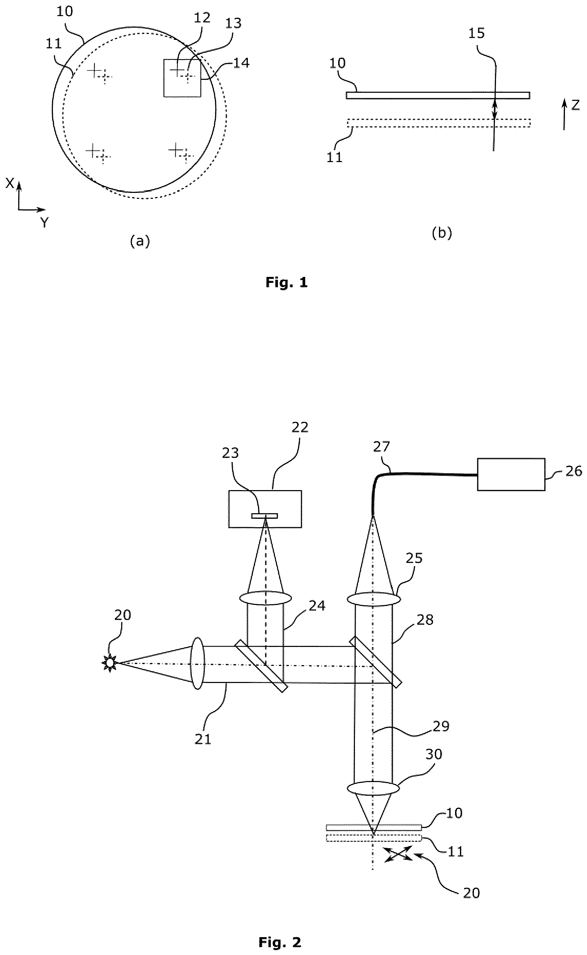

En référence à la Fig. 1, l'invention est destinée à être mise en oeuvre dans un système d'insolation utilisé en photolithographie notamment, et usuellement appelé « stepper ».

Un tel système comprend un support de wafer, ou chuck, dans lequel un wafer 11 recouvert de matériau photosensible peut être fixé.

Il comprend également un support de masque dans lequel un masque 10 peut être positionné face au wafer 11. Ce masque 10 comprend une plaque transparente (en général en quartz) sur laquelle sont déposés des motifs réalisés dans un matériau opaque (en général du chrome). Il comprend donc des zones transparentes et des zones opaques.

Une fois que le masque 10 est positionné correctement par rapport au wafer 11, l'ensemble est insolé au moyen d'une lumière ultraviolette. Ainsi, seul le matériau photosensible apparent dans les zones transparentes du masque est affecté. Cela permet de graver sur le wafer 11 des motifs qui servent à constituer des composants électroniques ou optiques notamment.

Dans la mesure où le traitement d'un wafer peut comprendre un grand nombre d'opérations d'insolation et de gravures successible, il est très important de positionner correctement le masque 10 par rapport aux motifs déjà existants à la surface du wafer 11.

Comme expliqué précédemment, ce positionnement doit être effectué dans le plan du wafer (en X-Y), en translation et en rotation. Pour cela, le masque comprend des motifs particuliers ou des mires 12, qui doivent être alignées avec d'autres mires 13 déjà gravées sur le wafer 11.

Afin d'optimiser la résolution, le masque 10 et le wafer 11 doivent être également positionnés précisément l'un par rapport à l'autre selon leur normale (Z), de sorte à être bien parallèles et séparés par une distance conforme à une valeur de consigne.

L'invention permet précisément d'effectuer ces alignements, simultanément, et sans contact.

En référence à la Fig. 2, le dispositif selon l'invention comprend des moyens d'imagerie.

Ces moyens d'imagerie permettent d'imager le masque 10 et le wafer 11 (au travers des parties transparentes du masque 10) selon un champ de vue 14.

Les moyens d'imagerie comprennent une source de lumière 20 et des moyens de collimation (lentilles, ...), qui permettent de générer un faisceau d'illumination 21 afin d'illuminer le champ de vue 14. La source de lumière 20 peut par exemple comprendre une lampe halogène qui émet une lumière dans les longueurs d'ondes visible.

Les moyens d'imagerie comprennent également une caméra 22 avec un détecteur matriciel 23, qui peut être par exemple de type CCD. Ils comprennent également des moyens optiques (lentilles, ...) qui permettent de former une image du champ de vue 14 sur le détecteur matriciel 23, à partir de la lumière 24 réfléchie ou rétrodiffusée par le masque 10 et le wafer 11.

Les moyens d'imagerie sont positionnés de telle sorte que l'axe optique 29 de l'illumination et de l'imagerie est sensiblement perpendiculaire au plan du masque 10 et du wafer 11. L'imagerie est dont effectuée en réflexion ou en rétrodiffusion.

Le dispositif selon l'invention comprend également un capteur optique de distance 26.

Ce capteur génère un faisceau de mesure 28 qui est inséré au moyen d'un collimateur 25 dans le système optique d'imagerie. Ce faisceau de mesure traverse l'objectif distal 30 des moyens d'imagerie pour former un spot de mesure 15 dans le champ de vue 14. Il permet ainsi de mesurer la distance entre le masque 10 le wafer 11, ou plus précisément la distance entre les faces en regard du masque 10 et du wafer 11. Cette mesure est ponctuelle, ou du moins réalisée en un point ou dans un petit voisinage 15 du champ de vue 14.

Les différents faisceaux (de mesure, d'imagerie, ...) sont combinés et/ou séparés dans le système optique au moyens d'éléments tels que des cubes séparateurs, des lames semi réfléchissantes, ... selon des techniques bien connues de l'homme du métier.

Le capteur de distance 26 met en oeuvre une technique de mesure basée sur l'interférométrie à faible cohérence dans le domaine spectral. La lumière d'une source optique à spectre large est amenée par une fibre optique 27 au collimateur 25. Les réflexions sur les surfaces du masque 10 et du wafer 11 de cette lumière issue du capteur de distance 26 sont collectées par ce même collimateur 25 et analysées dans un spectromètre. On obtient ainsi un spectre crénelé dans lequel les longueurs d'ondes optiques pour lesquelles les réflexions sur les faces du masque 10 et du wafer 11 sont en phase correspondent à des maxima. Une analyse de ce spectre permet de déduire précisément la distance entre le masque 10 et le wafer 11.

Le dispositif selon l'invention comprend également des premiers moyens de positionnement 20 qui permettent de maintenir et de déplacer le wafer 11 et le masque 10 l'un par rapport à l'autre. Ces moyens de positionnement peuvent comprendre tout système mécanique adapté, tel que des éléments de translation, rotation, bascule ...

Le dispositif selon l'invention comprend également des second moyens de positionnement (non représentés) qui permettent de déplacer le champ de vue 14 sur la surface du masque 10 et du wafer 11.

Ces seconds moyens de positionnement comprennent des platines de translation qui permettent de déplacer l'ensemble des moyens d'imagerie dans le plan X-Y du masque, de sorte à pouvoir positionner le champ de vue 14 en toute position de sur surface du masque 10 et du wafer 11.

Suivant des variantes de modes de réalisation, tout type de capteur optique de distance adapté peut être mis en oeuvre pour mesurer la distance entre le masque 10 et le wafer 11. On peut notamment citer :
- des capteurs mettant en oeuvre des techniques d'interférométrie à faible cohérence à balayage de fréquence, avec une source laser accordable et une analyse spectrale effectuée séquentiellement ;
- des capteurs mettant en oeuvre des techniques d'interférométrie à faible cohérence dans le domaine temporel, avec une ligne à retard pour reproduire le retard optique entre les signaux issus des réflexions sur les surfaces du masque 10 et du wafer 11 notamment ;

- des capteurs confocaux chromatique, dans lequel la position dans une étendue de mesure est codée en longueur d'onde au moyen d'un élément optique dispersif (par exemple au niveau du collimateur 25) qui introduit une aberration chromatique. La position des interfaces (du masque 10 et du wafer 11) peut ainsi être déduite d'une analyse spectrale du signal réfléchi ;
- des capteurs confocaux, dans lesquels la position des interfaces est déterminée à partir de la détection des maxima d'intensité de la lumière réfléchie au cours d'un balayage en profondeur (en Z) du point de focalisation du faisceau de mesure 15 ;
- des capteurs basés sur des techniques d'interférométrie laser.

Suivant des variantes de modes de réalisation, le dispositif selon l'invention peut comprendre des troisièmes moyens de positionnement qui permettent de déplacer la position du point de mesure 15 du capteur de distance dans le champ de vue 14 des moyens d'imagerie. Ces troisièmes moyens de positionnement peuvent par exemple comprendre des moyens de déplacement du collimateur de mesure 25.

Suivant des variantes de modes de réalisation, les premiers et les seconds moyens se positionnement peuvent être réalisés par les mêmes éléments, ou comprendre des éléments en commun.

Suivant des variantes de modes de réalisation, les seconds moyens de positionnement qui permettent de déplacer le champ de vue 14 sur la surface du masque 10 et du wafer 11 peuvent être réalisés par, ou comprendre, des éléments mobiles (miroirs de renvoi, ...) insérés dans les moyens optiques d'imagerie.

Suivant des variantes de modes de réalisation, le dispositif selon l'invention peut comprendre une pluralité de systèmes optiques d'imagerie tels que présentés à la Fig. 2, et des seconds moyens de positionnement pour positionner indépendamment les champs de vue de chacun de ces systèmes optiques d'imagerie sur la surface du masque 10.

En particulier, le dispositif selon l'invention peut comprendre trois systèmes optiques d'imagerie, ce qui permet d'ajuster les positions relatives du wafer 11 et du masque 10 en trois positions simultanément et de couvrir ainsi simultanément tous les degrés de liberté.

Suivant des modes de réalisation, le dispositif selon l'invention peut comprendre des moyens de commutation optiques (miroirs mobiles, ...) permettant d'imager séquentiellement plusieurs champs de vue 14 positionnés à différentes positions avec un même système d'imagerie.

L'alignement d'un masque 10 et d'un wafer 11 avec un dispositif selon l'invention comprend les étapes suivantes :
- le masque 10, la wafer 11 et le champ de vue 14 sont positionnés de telle sorte que les repères 12 du masque 10 à mettre en correspondance ou à superposer avec les repères 13 du wafer 11 soient visibles dans le même champ de vue 14.
- le wafer 11 et le masque 10 sont déplacés relativement l'un à l'autre dans le plan X-Y de telle sorte à mettre en correspondance les repères 12 du masque et les repères 13 du wafer.
- la position du champ de vue 14 et/ou la position 15 du faisceau de mesure dans le champ de vue 14 sont ajustés de telle sorte que le faisceau de mesure traverse une partie transparente du masque 10.
- la distance selon l'axe Z entre le wafer 11 et le masque 10 est mesurée et ajustée à sa valeur de consigne en déplaçant le wafer 11 relativement au masque 10.
- ces opérations de mesure et de positionnement sont effectuées (séquentiellement ou simultanément) à plusieurs positions à la surface du masque 10, pour plusieurs repères 12. En effet, il est nécessaire de les effectuer au moins à deux positions pour ajuster la rotation dans le plan X-Y du wafer 11 par rapport au masque 10, et à trois positions pour ajuster la distance entre le wafer 11 et le masque 10, de sorte que le wafer 11 et le masque 10 soient bien parallèles et séparés de la distance voulue. De préférence donc, ces opérations de mesure et de positionnement sont effectuées à trois positions à la surface du masque 10, ou à quatre positions pour obtenir une mesure redondante.

Ainsi, suivant un aspect particulièrement avantageux de l'invention, le wafer et le masque peuvent être positionnés très près l'un de l'autre, à une distance de quelques microns ou de quelques dizaines de microns, sans éléments en contact mécanique avec leur surface.

Suivant des variantes de modes de réalisation, au moins un des capteurs de distance mis en oeuvre peut être en outre apte à effectuer une mesure de l'épaisseur de la couche photosensible, ou couche de resist.

Il est ainsi possible de mesurer la distance entre le masque 10 et le wafer 11, ou plus précisément entre le masque 10 et la surface supérieure du resist présent sur le wafer 11, et l'épaisseur de resist présente au dessus de la couche à graver.

Ce ou ces capteur(s) de distance peuvent être également aptes à effectuer une mesure de réflectivité de la surface de la couche à graver présente sur le wafer 11 en dessous de la couche de resist.

Ce mode de mise en oeuvre peut être réalisé avec tous types de capteurs de distance adaptés, dont en particulier ceux mentionnés précédemment (capteur confocal ; capteur confocal chromatique ; interféromètre à faible cohérence temporelle, spectrale, à balayage de fréquence ; réflectomètre ; interféromètre laser, ...). Les capteurs doivent simplement être mis en oeuvre dans des configurations adaptées à la réalisation de mesures multicouches, bien connues de l'homme du métier, et avec des longueurs d'onde de mesure aptes à pénétrer le resist (dans l'infrarouge proche par exemple).

La mesure de la réflectivité peut être obtenue à partir de l'intensité du signal de mesure réfléchi.

Les mesures de l'épaisseur du resist et de la réflectivité de la couche à graver sont des informations nécessaires pour pouvoir ajuster l'énergie (temps d'exposition et/ou puissance) à appliquer lors de l'étape d'insolation.

Ainsi, avantageusement, l'invention permet de mesurer et d'ajuster avec un seul système un ensemble de paramètres essentiels pour l'insolation (la distance masque-wafer, l'épaisseur de resist et le réflectivité de la couche à graver).

En outre, il est possible de déterminer la distance entre le masque 10 et la surface à graver (en incluant l'épaisseur de la couche de resist), et ainsi d'ajuster la distance entre la surface du wafer 11 et le masque 10 en tenant compte de l'épaisseur de la couche de resist.

Suivant une variante, le dispositif selon l'invention peut comprendre au moins un second capteur, distinct du ou des capteur(s) optique de distance 26, pour mesurer l'épaisseur de la couche de resist et/ou la réflectivité de la couche à graver.

Ce second capteur peut comprendre également un faisceau de mesure qui traverse au moins en partie les moyens d'imagerie. Il peut être agencé de telle façon à effectuer des mesures dans le champ de vue 14 du système d'imagerie.

Bien sûr, l'invention n'est pas limitée aux exemples qui viennent d'être décrits et de nombreux aménagements peuvent être apportés à ces exemples sans sortir du cadre de l'invention.

## Revendications

1. Dispositif pour positionner un masque (10) relativement à la surface d'un wafer (11) en vue de l'insolation dudit wafer (11), comprenant :
- des premiers moyens de positionnement (20) aptes à maintenir et à déplacer l'un par rapport à l'autre ledit masque (10) et ledit wafer (11),
- des moyens d'imagerie (20, 22, 23, 30), aptes à produire au moins une image du masque (10) et de la surface du wafer (11) selon au moins un champ de vue (14), de telle sorte à imager simultanément dans ledit champ de vue (14) des repères de positionnement (12, 13) dudit masque (10) et dudit wafer (11) ;
ledit dispositif étant **caractérisé en ce qu'**il comprend au moins un capteur optique de distance (26), apte à produire une mesure de distance entre la surface du wafer (11) et le masque (10) dans le ou lesdits champ(s) de vue (14), avec un faisceau de mesure (28) qui traverse au moins en partie les moyens d'imagerie pour former un spot de mesure (15) dans ce ou ces champ(s) de vue (14).

2. Le dispositif de la revendication 1, qui comprend en outre des seconds moyens de positionnement aptes à déplacer le ou les champ(s) de vue (14) relativement à la surface du wafer (11).

3. Le dispositif de l'une des revendications 1 ou 2, qui comprend des moyens d'imagerie aptes à produire simultanément au moins trois images selon trois champs de vue (14).

4. Le dispositif de la revendication 3, qui comprend au moins trois capteurs optiques de distance (26).

5. Le dispositif de l'une des revendications précédentes, qui comprend au moins un capteur optique de distance (26) de l'un des types suivants :
- capteur confocal,
- capteur confocal chromatique,
- interféromètre à faible cohérence,
- réflectomètre,
- interféromètre laser.

6. Le dispositif de l'une des revendications précédentes, qui comprend au moins un capteur de distance (26) qui est en outre apte à produire au moins l'une des mesures suivantes :
- une mesure d'épaisseur de la couche de resist,
- une mesure de réflectivité de la couche à graver présente sous la couche de resist.

7. Appareil d'insolation de wafers, comprenant un dispositif selon l'une quelconque des revendications précédentes.

8. Procédé pour positionner un masque (10) relativement à la surface d'un wafer (11) en vue de l'insolation dudit wafer (11), mettant en oeuvre des premiers moyens de positionnement (20) aptes à maintenir et à déplacer l'un par rapport à l'autre ledit masque (10) et ledit wafer (11), ledit procédé comprenant une étape d'obtention d'au moins une image du masque (10) et de la surface du wafer (11) selon au moins un champ de vue (14), de telle sorte à imager simultanément dans ledit champ de vue (14) des repères de positionnement (12, 13) dudit masque (10) et dudit wafer (11), ledit procédé étant **caractérisé en ce qu'**il comprend en outre une étape d'obtention, avec au moins un capteur optique de distance (26) et un faisceau de mesure (28) qui traverse au moins en partie les moyens d'imagerie pour former un spot de mesure (15) dans le ou lesdits champ(s) de vue (14), d'au moins une mesure de distance entre la surface du wafer (11) et le masque (10) dans ce ou ces champ(s) de vue (14).

9. Le procédé de la revendication 8, qui comprend en outre une étape de déplacement relatif du masque (10) et/ou du wafer (11) de telle sorte à, dans au moins un champ de vue (14) :
- superposer des repères de positionnement (12, 13) du masque (10) et du wafer (11),
- obtenir une mesure de distance entre la surface du wafer (10) et le masque (11) qui soit conforme à une valeur prédéfinie.

10. Le procédé de l'une des revendications 8 ou 9, qui comprend une étape d'obtention, simultanément, d'au moins trois images selon trois champs de vue (14).

11. Le procédé de l'une des revendications 8 à 10, qui comprend en outre une étape de mesure, avec le capteur optique de distance (26), d'au moins l'une des grandeurs suivantes :
- l'épaisseur de resist présent sur le wafer (11),
- la réflectivité de la couche à graver présente sous le resist, à partir du signal capté par ledit capteur optique de distance (26).

## Patentansprüche

1. Vorrichtung zur Positionierung einer Maske (10) relativ zu der Oberfläche eines Wafers (11) im Hinblick auf die Belichtung des Wafers (11), umfassend:
- erste Positionierungsmittel (20), die geeignet sind, die Maske (10) und den Wafers (11) zu halten und relativ zueinander zu verschieben,
- Bildgebungsmittel (20, 22, 23, 30), die geeignet sind, mindestens ein Bild der Maske (10) und der Oberfläche des Wafers (11) nach mindestens einem Sichtfeld (14) zu erzeugen, sodass in dem Sichtfeld (14) jeweils Positionierungsmarkierungen (12, 13) der Maske (10) und des Wafers (11) gleichzeitig abgebildet werden;
wobei die Vorrichtung **dadurch gekennzeichnet ist, dass** sie wenigstens einen optischen Abstandssensor (26) umfasst, welcher dazu geeignet ist, einen Messwert für den Abstand zwischen der Waferoberfläche (11) und der Maske (10) in dem mindestens einen Sichtfeld (14) mittels eines Messstrahls (28) zu erzeugen, welcher zur Bildung einer Messlichtmarke (15) in diesem mindestens einen Sichtfeld (14) mindestens teilweise durch die Bildgebungsmittel hindurchtritt.

2. Vorrichtung nach Anspruch 1, welche außerdem zweite Positionierungsmittel umfasst, die zur Verschiebung des mindestens einen Sichtfeldes (14) relativ zu der Oberfläche des Wafers (11) geeignet sind.

3. Vorrichtung nach einem der Ansprüche 1 oder 2, welche Bildgebungsmittel umfasst, die zur gleichzeitigen Erzeugung mindestens dreier Bilder nach drei Sichtfeldern (14) geeignet sind.

4. Vorrichtung nach Anspruch 3, welche mindestens drei optische Abstandssensoren (26) umfasst.

5. Vorrichtung nach einem der vorhergehenden Ansprüche, welche mindestens einen optischen Abstandssensor (26) von einem der folgenden Typen umfasst:
- Konfokalsensor,
- chromatisch-konfokaler Sensor,
- Niedrigkohärenzinterferometer,
- Reflektometer,
- Laserinterferometer.

6. Vorrichtung nach einem der vorhergehenden Ansprüche, welche mindestens einen optischen Abstandssensor (26) umfasst, welcher außerdem zur Angabe mindestens eines der folgenden Messwerte geeignet ist:
- ein Messwert für die Dicke der Fotolackschicht,
- ein Messwert für die Reflektivität der unter der Fotolackschicht liegenden, zu ätzenden Schicht.

7. Gerät zur Belichtung von Wafern, welches eine Vorrichtung nach einem der vorhergehenden Ansprüche umfasst.

8. Verfahren zur Positionierung einer Maske (10) relativ zu der Oberfläche eines Wafers (11) im Hinblick auf die Belichtung des Wafers (11), wobei erste Positionierungsmittel (20) eingesetzt werden, welche dazu geeignet sind, die Maske (10) und den Wafer (11) zu halten und relativ zueinander zu verschieben, wobei das Verfahren einen Schritt zur Gewinnung mindestens eines Bildes der Maske (10) und der Oberfläche des Wafers (11) nach mindestens einem Sichtfeld (14) derart umfasst, sodass in dem Sichtfeld (14) Positionierungsmarkierungen (12, 13) der Maske (10) und des Wafers (11) gleichzeitig abgebildet werden, wobei das Verfahren **dadurch gekennzeichnet ist, dass** es außerdem einen Schritt zur Gewinnung mindestens eines Messwerts für den Abstand zwischen der Oberfläche des Wafers (11) und der Maske (10) in dem mindestens einen Sichtfeld (14) anhand mindestens eines optischen Abstandssensors (26) und eines Messstrahls (28) umfasst, wobei der Messstrahl (28) zur Bildung einer Messlichtmarke (15) in dem mindestens einen Sichtfeld (14) mindestens teilweise durch die Bildgebungsmittel hindurchtritt.

9. Verfahren nach Anspruch 8, welches außerdem einen Schritt der relativen Verschiebung der Maske (10) und/oder des Wafers (11) derart umfasst, sodass in mindestens einem Sichtfeld (14):
- Positionierungsmarkierungen (12, 13) der Maske (10) und des Wafers (11) übereinander gesetzt werden,
- ein Messwert für den Abstand zwischen der Oberfläche des Wafers (10) und der Maske (11) erreicht wird, welcher mit einem vordefinierten Wert übereinstimmt.

10. Verfahren nach einem der Ansprüche 8 oder 9, welches einen Schritt der gleichzeitigen Gewinnung dreier Bilder nach drei Sichtfeldern (14) umfasst.

11. Verfahren nach einem der Ansprüche 8 bis 10, welches außerdem einen Schritt zur Messung mindestens eines der folgenden Werte anhand des optischen Abstandssensors (26) umfasst:
- die Dicke des auf dem Wafer (11) liegenden Fotolacks,
- die Reflektivität der zu ätzenden, unter dem Fotolack liegenden Schicht anhand des durch den optischen Abstandssensor (26) erfassten Signals.

## Claims

1. Device for positioning a mask (10) relative to the surface of a wafer (11) with a view to the exposure of said wafer (11), comprising:
- first positioning means (20) suitable for holding and moving said mask (10) and said wafer (11) in relation to each other,
- imaging means (20, 22, 23, 30), suitable for producing at least one image of the mask (10) and of the surface of the wafer (11) according to at least one field of view (14), so as to image positioning marks (12, 13) of said mask (10) and of said wafer (11) simultaneously in said field of view (14),
the device being **characterized in that** it comprises at least one optical distance sensor (26), suitable for producing a distance measurement between the surface of the wafer (11) and the mask (10) in the field(s) of view (14) with a measurement beam (28) which passes at least partially through the imaging means in order to form a measurement spot (15) in this or these field(s) of view (14).

2. The device of claim 1, which comprises in addition second positioning means suitable for moving the field(s) of view (14) relative to the surface of the wafer (11).

3. The device of one of claims 1 or 2, which comprises imaging means suitable for simultaneously producing at least three images according to three fields of view (14).

4. The device of claim 3, which comprises at least three optical distance sensors (26).

5. The device of one of the preceding claims, which comprises at least one optical distance sensor (26) of one of the following types:
- confocal sensor,
- chromatic confocal sensor,
- low-coherence interferometer,
- reflectometer,
- laser interferometer.

6. The device of one of the preceding claims, which comprises at least one distance sensor (26) which is also suitable for producing at least one of the following measurements:
- a measurement of the thickness of the resist layer,
- a measurement of the reflectivity of the layer to be etched, this layer being present below the resist layer.

7. Appliance for the exposure of wafers, comprising a device according to any one of the preceding claims.

8. Method for positioning a mask (10) relative to the surface of a wafer (11) with a view to the exposure of said wafer (11), utilizing first positioning means (20) suitable for holding and moving said mask (10) and said wafer (11) in relation to each other, the method comprising a step of obtaining at least one image of the mask (10) and of the surface of the wafer (11) according to at least one field of view (14), so as to image positioning marks (12, 13) of said mask (10) and of said wafer (11) simultaneously in said field of view (14), the method being **characterized in that** it further comprises a step of obtaining, with at least one optical distance sensor (26) and a measurement beam (28) which passes at least partially through the imaging means in order to form a measurement spot (15) in the field(s) of view (14), at least one distance measurement between the surface of the wafer (11) and the mask (10) in this or these field(s) of view (14).

9. The method of claim 8, which comprises in addition a step of relative movement of the mask (10) and/or of the wafer (11) so as to, in at least one field of view (14):
- superimpose positioning marks (12, 13) of the mask (10) and of the wafer (11),
- obtain a distance measurement between the surface of the wafer (10) and the mask (11) which is in accordance with a predefined value.

10. The method of one of claims 8 or 9, which comprises a step of obtaining, simultaneously, at least three images according to three fields of view (14).

11. The method of one of claims 8 to 10, which comprises in addition a step of measuring, with the optical distance sensor (26), at least one of the following values:
- the thickness of the resist layer present on the wafer (11),
- the reflectivity of the layer to be etched, this layer being present below the resist layer, from the signal acquired by said optical distance sensor (26).
